# EUROPÄISCHE PATENTSCHRIFT

(11) **EP 3 489 703 B1**
(45) Veröffentlichungstag und Bekanntmachung des Hinweises auf die Patenterteilung: **17.04.2024**
(21) Anmeldenummer: 18177924.0
(22) Anmeldetag: 15.06.2018
(51) Int. Cl.: G01R 31/389, G01R 31/374

(54) **VERFAHREN ZUR BESTIMMUNG EINES AKTUELLEN LADEZUSTANDSWERTS EINER BATTERIE, BATTERIEANORDNUNG UND KRAFTFAHRZEUG**
METHOD FOR DETERMINING A CURRENT CHARGE LEVEL OF A BATTERY, BATTERY ASSEMBLY AND MOTOR VEHICLE
PROCÉDÉ DE DÉTERMINATION D'UNE VALEUR D'ÉTAT DE CHARGEMENT ACTUEL D'UNE BATTERIE, DISPOSITIF BATTERIE ET VÉHICULE AUTOMOBILE

(30) Priorität: 28.11.2017 DE 102017221248
(43) Veröffentlichungstag der Anmeldung: 29.05.2019
(73) Patentinhaber: AUDI AG, 85045 Ingolstadt (DE)
(72) Erfinder: Naumann, Rolf, 85055 Etting (DE); Kraus, Matthias, 85123 Karlskron (DE)

(56) Entgegenhaltungen:
- DE-A1- 19 903 239
- DE-A1-102005 052 448
- DE-A1-102009 058 893
- FR-A1- 2 749 397

## Beschreibung

Die Erfindung betrifft ein Verfahren zur Bestimmung eines aktuellen Ladezustandswerts einer Batterie eines bestimmten Batterietyps sowie eine Batterieanordnung mit einer Batterie eines bestimmten Batterietyps und einer Steuereinrichtung zum Bestimmen eines aktuellen Ladezustandswerts der Batterie. Zur Erfindung gehört auch ein Kraftfahrzeug mit einer solchen Batterieanordnung.

Um einen fehlerfreien und sicheren Betrieb im Energienetz eines Kraftfahrzeugs sicherstellen zu können, spielt die Bestimmung des Ladezustands, der üblicherweise auch mit SOC (state of charge) bezeichnet wird, von Bordnetz- oder Traktionsbatterien, insbesondere als Bestandteil der Batteriezustandserkennung, eine wichtige Rolle. Im automobilen Umfeld gibt es bereits mehrere bekannte Methoden, um diese Bestimmung zu realisieren. Bei gegebenem Initialzustand des Ladezustands und bekannter Kapazität der Batterie ist es beispielsweise möglich, mittels Stromintegration die Veränderung des Ladezustands bei Belastung, zum Beispiel beim Laden oder Entladen, zu bestimmen. Darüber hinaus gibt es das Verfahren der sogenannten 100 prozentigen Rekalibrierung bei vollgeladener Batterie. Eine weitere übliche Methode ist die Messung der Batterieruhespannung, die eine sehr genaue Aussage über den aktuellen Ladezustand einer Batterie ermöglicht.

Nachteilig bei diesen bekannten Verfahren ist, dass sie entweder sehr ungenau sind oder nur unter ganz speziellen Voraussetzungen durchführbar sind. Beispielsweise führt die Methode zur Ladezustandsbestimmung mittels Stromintegration zu einem über die Zeit anwachsenden Fehler, der mittelfristig zu einer deutlichen Abweichung vom tatsächlichen Ladezustand der Batterie führt. Die bekannten Rekalibrierungsmethoden könnten hierbei zwar Abhilfe schaffen, sind jedoch auf spezielle Umgebungs- und Systembedingungen angewiesen, wie beispielsweise eine vollgeladene Batterie oder Ruhespannungsverhältnisse. Damit jedoch eine Rekalibrierung mittels der Messung der Batterieruhespannung überhaupt möglich ist, muss die Charakteristik zwischen dem Ladezustand und der Batterieruhespannung der jeweils eingesetzten Zellchemie eine eindeutige Zuordnung zwischen dem Ladezustand und der Batterieruhespannung zulassen. Bei einigen Zellchemien, wie zum Beispiel bei einem Lithium-Eisenphosphat-Akkumulator (LiFePO4) ist dies nicht der Fall, was durch die flache Kennlinie begründet ist.

In diesem Zusammenhang beschreibt beispielsweise die DE 10 2013 206 189 A1 ein Verfahren zum Bestimmen eines Ladezustands eines Akkumulators, bei welchem der Ladezustand anhand eines Spannungsdifferenzials, das heißt der Ableitung der Spannungskurve des Akkumulators, über eine geeignete Variable, ermittelt wird.

Darüber hinaus beschreibt die DE 11 2013 006 736 T5 ein Verfahren und ein Gerät für ein Schätzen einer verbleibenden Batteriekapazität, gemäß welchem die Batteriekapazität bestimmt wird, wenn zwischen einem Aufladen und einem Entladen der Batterie gewechselt wird. Die Bestimmung der Kapazität basiert dabei auf der Erfassung der Entladespannung der Batterie. Auch hierbei kann die Bestimmung der Kapazität nur in einer bestimmten Situation, nämlich beim Wechseln zwischen Aufladen und Entladen der Batterie, erfolgen.

Die DE 10 2005 052 448 A1 beschreibt ein Verfahren zum Ermitteln einer Funktionsfähigkeit einer Batterie, gemäß welchem die Leerlaufspannung sowie der Innenwiderstand in Form von Kennlinien in Abhängigkeit von der Temperatur und des Ladezustands abgelegt werden und durch Messung der Leerlaufspannung, des Innenwiderstands und der Temperatur und durch anschließendes Rückwärtsablesen der Kennlinien ein Schätzwert des Ladezustands bestimmt wird.

Die DE 199 03 239 A1 beschreibt ein Verfahren zur Ermittlung des Ladezustandes einer an einem Ladegerät angeschlossenen Batterie, gemäß welchem ein Innenwiderstand errechnet wird, durch die Anzahl der Zellen der Batterie geteilt wird und der Ladezustand aus einer Innenwiderstands-Kennlinie ermittelt wird.

Die DE 10 2009 058 893 A1 beschreibt ein Verfahren zur Überwachung eines Batterieladezustands, bei dem ein Ladezustandswert mittels Stromintegration ermittelt wird und bei dem mittels Batterieparametern ein Maximalwert und/oder Minimalwert zur jeweiligen Begrenzung des Ladezustandswerts und/oder ein Referenzwert zum Rücksetzen des Ladezustandswerts ermittelt wird.

Aufgabe der vorliegenden Erfindung ist es daher, ein Verfahren zur Bestimmung eines aktuellen Ladezustandswerts einer Batterie, eine Batterieanordnung und ein Kraftfahrzeug bereitzustellen, welche eine möglichst einfache und genaue Bestimmung des Ladezustandswerts erlauben.

Diese Aufgabe wird gelöst durch ein Verfahren zur Bestimmung eines aktuellen Ladezustandswerts einer Batterie, durch eine Batterieanordnung und durch ein Kraftfahrzeug mit den Merkmalen gemäß den jeweiligen unabhängigen Ansprüchen. Vorteilhafte Ausgestaltungen der Erfindung sind Gegenstand der abhängige Patentansprüche, der Beschreibung sowie der Figuren.

Bei einem erfindungsgemäßen Verfahren zur Bestimmung eines aktuellen Ladezustandswerts einer Batterie eines bestimmten Batterietyps wird ein Kennlinienfeld bereitgestellt, welches für jeweilige verschiedene vorbestimmte Temperaturbereiche einen Innenwiderstand für den bestimmten Batterietyp in Abhängigkeit von dem Ladezustand für den bestimmten Batterietyp angibt. Weiterhin wird eine aktuelle Temperatur der Batterie gemessen und ein aktueller Innenwiderstandswert der Batterie ermittelt. Auf Basis der aktuellen Temperatur und des aktuellen Innenwiderstandswerts wird der aktuelle Ladezustandswert der Batterie mittels des Kennlinienfeldes bestimmt. Weiterhin wird, falls die gemessene aktuelle Temperatur in einem der vorbestimmten Temperaturbereiche liegt, in welchem die Abhängigkeit des Innenwiderstands vom Ladezustand für einen Innenwiderstandswert des Kennlinienfeldes ein Extremum aufweist, der Ladezustandswert der Batterie mittels des Kennlinienfeldes derart bestimmt, dass überprüft wird, ob mindestens zwei Ladezustandswerte im Kennlinienfeld existieren, die gemäß der Abhängigkeit dem gemessenen Innenwiderstandswert für den vorbestimmten Temperaturbereich, in welchem die aktuelle Temperatur liegt, zugeordnet ist, und falls ja, die mindestens zwei Ladezustandswerte aus dem Kennlinienfeld bestimmt werden und der aktuelle Ladezustandswert der Batterie gemäß einem vorbestimmten Auswahlverfahren mit einem der mindestens zwei Ladezustandswerte gleichgesetzt wird. Gemäß dem vorbestimmten Auswahlverfahren wird der Ladezustandswert der Batterie mit einem der mindestens zwei aus dem Kennlinienfeld bestimmten Ladezustandswerte gleichgesetzt wird in Abhängigkeit von einem in einem vorhergehenden Zeitschritt ermittelten Innenwiderstandswert und/oder in Abhängigkeit von einer aktuellen Ladesituation der Batterie, das heißt in Abhängigkeit davon, ob die Batterie aktuell geladen oder entladen wird.

Sowohl die aktuelle Batterietemperatur als auch der aktuelle Innenwiderstandswert der Batterie lassen sich auf einfache Weise ermitteln. Insbesondere kann sowohl die Batterietemperatur als auch der Innenwiderstand über ein Verfahren bestimmt werden, die vom Ladezustand unabhängig sind, das heißt Verfahren, die eine Bestimmung der Temperatur und des Innenwiderstands auch ohne Kenntnis des aktuellen Ladezustands der Batterie ermöglichen. Somit lässt sich dann entsprechend der aktuelle Ladezustand auf Basis des ermittelten aktuellen Innenwiderstandswerts und der aktuellen Temperatur mittels des Kennlinienfeldes bestimmen. Darüber hinaus kann eine solche Ermittlung quasi in jeder beliebigen Betriebssituation der Batterie und des Kraftfahrzeugs, wenn die Batterie beispielsweise in einem Kraftfahrzeug Anwendung findet, stattfinden. Daraus ergeben sich deutlich weniger situative Einschränkungen bezüglich der Ermittlung des Ladezustandswerts einer Batterie. Insbesondere wird hierdurch sogar eine kontinuierliche und fortwährende Überwachung und Bestimmung des Ladezustandswerts der Batterie ermöglicht. Auch gibt es hierbei keinerlei Beschränkungen bezüglich der Art der Batterie beziehungsweise des Batterietyps, der sich in diesem Zusammenhang auf die in der Batterie verwendete Zellchemie bezieht. Ein entsprechendes Kennlinienfeld, das heißt ein Kennlinienfeld für einen bestimmten Batterietyp, lässt sich auf einfache Weise, zum Beispiel experimentell, für jeden beliebigen Batterietyp bereitstellen und für das erfindungsgemäße Verfahren damit auf einfache Weise für jeden bestimmten Batterietyp verwenden. Zur Ermittlung eines solchen Kennlinienfeldes kann beispielsweise eine Testbatterie eines bestimmten Zelltyps bereitgestellt werden und dann für verschiedene Temperaturen in den vorbestimmten verschiedenen Temperaturbereichen für verschiedene Ladezustände, zum Beispiel wenn die Testbatterie sukzessive entladen wird oder geladen wird, der jeweilige zugehörige Innenwiderstandswert der Testbatterie ermittelt werden. Dabei kann auch eine quasi kontinuierliche Vermessung des Innenwiderstands für einen kontinuierlich abnehmenden oder zunehmenden Ladezustand der Testbatterie erfolgen, so dass letztendlich für einen jeweiligen vorbestimmten Temperaturbereich eine entsprechende kontinuierlich verlaufende Kennlinie bereitgestellt werden kann, die für den bestimmten Batterietyp den Zusammenhang zwischen Innenwiderstand und Ladezustand beschreibt. Die so erhaltenen Ergebnisse beziehungsweise Kennlinien können dann in einem Kennlinienfeld für den bestimmten Batterietyp niedergelegt werden. Dies kann für vielzählige Testbatterien verschiedener Batterietypen, das heißt mit verschiedenen Zellchemien, durchgeführt werden. Somit kann für einen jeweiligen Batterietyp das passende Kennlinienfeld bereitgestellt werden. Zudem lässt sich der Zusammenhang zwischen Batterietemperatur, Innenwiderstand der Batterie und dem Ladezustand der Batterie experimentell besonders genau bestimmen, sodass auf Basis eines solchen Kennlinienfelds auch eine besonders genaue Ermittlung des aktuellen Ladezustandswerts der Batterie ermöglicht wird. Hierdurch lässt sich das erfindungsgemäße Verfahren sowohl auf besonders vorteilhafte Weise für jede beliebige Zellchemie, das heißt für jeden Batterietyp, uneingeschränkt verwenden und gleichzeitig der Ladezustand auf besonders genaue Weise in fast jeder beliebigen Situation ermitteln. So kann das erfindungsgemäße Verfahren beispielsweise auch bei Zellchemien wie zum Beispiel bei Lithium-Eisenphosphat-Akkumulatoren Anwendung finden. So kann nun vorteilhafterweise eine Ladezustandsbestimmung beziehungsweise Rekalibrierung des Ladezustands mit dem Wissen über den Innenwiderstand und der Temperatur auf besonders einfache und effiziente Weise erfolgen.

In der Praxis hat sich gezeigt, dass je nach Zellchemie nicht immer eine eindeutige Zuordnung zwischen dem Innenwiderstand und dem Ladezustand möglich ist. Beispielsweise gibt es Fälle, in denen die Kennlinie für einen bestimmten Temperaturbereich oder auch mehrere oder alle bestimmten Temperaturbereiche ein Maximum oder ein Minimum oder auch mehrere solcher Extrema aufweist. Entsprechend kann es auch vorkommen, dass für einen bestimmten Temperaturbereich einem gegebenen Innenwiderstandswert mehr als nur ein Ladezustandswert zuordenbar ist. Daher ist es vorteilhaft, dass, falls die gemessene aktuelle Temperatur in einem der vorbestimmten Temperaturbereiche liegt, in welchem die Abhängigkeit des Innenwiderstands vom Ladezustand für einen Innenwiderstandswert des Kennlinienfeldes ein Extremum aufweist, der Ladezustandswert der Batterie mittels des Kennlinienfeldes derart bestimmt wird, dass überprüft wird, ob mindestens zwei Ladezustandswerte im Kennlinienfeld existieren, die gemäß der Abhängigkeit dem gemessenen Innenwiderstandswert für den vorbestimmten Temperaturbereich, in welchem die aktuelle Temperatur liegt, zugeordnet ist, und fallsja, die mindestens zwei Ladezustandswerte aus dem Kennlinienfeld bestimmt werden und der aktuelle Ladezustandswert der Batterie gemäß einem vorbestimmten Auswahlverfahren mit einem der mindestens zwei Ladezustandswerte gleichgesetzt wird. So kann nun vorteilhafterweise überprüft werden, ob es mehr als nur eine mögliche Zuordnung des Innenwiderstandswerts zum korrespondierenden Ladezustandswert gibt. Sollte dies insbesondere nicht der Fall sein, so kann, wie nachfolgend beschrieben, vorgegangen werden und einfach für die gemessene Temperatur und den ermittelten Innenwiderstandswert der korrespondierende Ladezustandswert aus dem Kennlinienfeld ausgelesen werden. Gibt es nun jedoch mehr als nur einen zuordenbaren Ladezustandswert zu einem gemessenen beziehungsweise ermittelten Innenwiderstandswert, so gibt es weitere vorteilhafte Möglichkeiten, um zu ermitteln, welcher dieser mindestens zwei möglichen Ladezustandswerte nun den aktuellen Ladezustandswert der Batterie darstellt.

Unter einer Batterie kann im Zusammenhang mit der Erfindung im Allgemeinen jeder beliebige Energiespeicher, insbesondere elektrochemischer Energiespeicher, verstanden werden. Vorzugweise ist die Batterie als ein auf Lithium-lonen-Technologie basierender Energiespeicher ausgebildet. Vorzugsweise findet die Erfindung Anwendung bei Kraftfahrzeugen. In diesem Zusammenhang kann die Batterie eine Kraftfahrzeugbatterie darstellen, wie beispielsweise eine Bordnetzbatterie oder Traktionsbatterie. Die Erfindung kann aber auch in ganz anderen Anwendungsgebieten Anwendung finden, wie zum Beispiel bei elektronischen Geräten, die als Energieversorgung eine Batterie beziehungsweise einen Akkumulator oder im Allgemeinen einen elektrochemischen Energiespeicher, insbesondere einen wieder aufladbaren Energiespeicher, als Energiequelle verwenden. Derartige elektronische Geräte können zum Beispiel Tablets, Smartphones, Laptops, Smartwatches oder ähnliches darstellen.

Unter einem Ladezustandswert ist dabei im Allgemeinen der Wert als numerische Größe des Ladezustands der Batterie zu verstehen. Entsprechend ist auch unter dem Innenwiderstandswert der Wert als numerische Größe des Innenwiderstands der Batterie zu verstehen.

Der letztendlich bestimmte aktuelle Ladezustandswert der Batterie kann als entsprechendes Signal bereitgestellt werden, in Abhängigkeit von welchem eine Funktion ausgelöst wird. Eine solche Funktion kann eine Steuerungsfunktion zum Steuern zumindest einer Komponenten, zum Beispiel der Batterieanordnung oder des Kraftfahrzeugs, sein oder ein weiterer Berechnungsschritt, eine Rekalibrierung des Ladezustands oder das Anzeigen des aktuellen Ladezustands oder einer korrespondierenden Information, wie zum Beispiel einer prognostizierten Reichweite oder eine Aufforderung zum Laden oder Ähnliches, auf einem Display, oder auch ein Speichern der aktuell ermittelten Ladezustandswerte in einem Speicher.

Weiterhin können beliebig viele verschiedene vorbestimmte Temperaturbereiche definiert sein. Beispielsweise kann ein jeweiliger Temperaturbereich 1°C bemessen zumindest über einen maximal einstelligen Grad-Celsius-bereich ausgedehnt sein. Die Gesamtheit der jeweiligen verschiedenen Temperaturbereiche deckt dabei einen Gesamttemperaturbereich ab, der anwenungsspezifisch festgelegt werden kann. Für Anwendungen im Kraftfahrzeugbereich kann sich dieser Gesamttemperaturbereich beispielsweise von -30°C bis 75°C erstrecken. Für andere Anwendungsgebiete, zum Beispiel in mobilen Kommunikationsgeräten, kann der Gesamttemperaturbereich anders bemessen sein und deck vorzugsweise alle möglichen Betriebstemperaturen der Batterie ab.

Bei einer vorteilhaften Ausgestaltung der Erfindung wird, falls die gemessene aktuelle Temperatur der Batterie in einem der vorbestimmten Temperaturbereiche liegt, in welchem die Abhängigkeit des Innenwiderstands von dem Ladezustand streng monoton steigt oder fällt, der Ladezustandswert der Batterie mittels des Kennlinienfeldes derart bestimmt, dass der Ladezustandswert der Batterie gleich einem Ladezustandswert des Kennlinienfeldes gesetzt wird, der für den vorbestimmten Temperaturbereich, in welchem die aktuell gemessene Temperatur der Batterie liegt, gemäß der Abhängigkeit dem aktuell gemessenen Innenwiderstandswert zugeordnet ist. Für den Fall also, dass für einen bestimmten Temperaturbereich eine eindeutige Zuordnungsmöglichkeit des Innenwiderstandswerts zum Ladezustand für den bestimmten Batterietyp gegeben ist, was der Fall ist, wenn die den Zusammenhang zwischen Innenwiederstand und ladezustand beschreibende Kennlinie streng monoton steigt oder streng monoton fällt, so kann für eine ermittelte aktuelle Temperatur und den aktuellen Innenwiderstandswert der zugeordnete Ladezustandswert der Batterie auf besonders einfache Weise aus dem Kennlinienfeld ausgelesen werden.

Des Weiteren ist es gemäß einer weiteren vorteilhaften Ausgestaltung der Erfindung bzw. erfindungsgemäß vorgesehen, dass gemäß dem vorbestimmten Auswahlverfahren der Ladezustandswert der Batterie mit einem der mindestens zwei aus dem Kennlinienfeld bestimmten Ladezustandswerte gleichgesetzt wird in Abhängigkeit von einem in einem vorhergehenden Zeitschritt ermittelten Innenwiderstandswert und/oder in Abhängigkeit von der Art des Extremums, das heißt in Abhängigkeit davon, ob das Extremum ein Minimum oder ein Maximum darstellt und/oder in Abhängigkeit von einer aktuellen Ladesituation der Batterie, das heißt in Abhängigkeit davon, ob die Batterie aktuell geladen oder entladen wird.

Diese Vorgehensweise ist besonders vorteilhaft, wenn die entsprechende Kennlinie, die für einen bestimmten Temperaturbereich den Zusammenhang zwischen dem Innenwiderstand und dem Ladezustand beschreibt, nur ein einziges Extremum, das heißt entweder ein Minimum oder ein Maximum, aufweist. Dabei ist auch die Kenntnis darüber, ob es sich bei diesem Extremum um ein Maximum oder ein Minimum handelt, von Vorteil. Diese Information kann auf einfache Weise durch die entsprechenden Kennlinien des Kennlinienfeldes ermittelt werden. Besonders vorteilhaft ist es in einer solchen Situation, wenn die zeitlich aufeinanderfolgend bestimmten Innenwiderstandswerte der Batterie betrachtet und zum Beispiel verglichen werden, um den richtigen Ladezustandswert der zwei möglichen Ladezustandswerte aus dem Kennlinienfeld zu bestimmen. Wenn nun beispielsweise der Innenwiderstand mit zunehmendem Ladezustand der Batterie gemäß der entsprechenden Kennlinie für einen bestimmten Temperaturbereich zunächst abfällt bis zu einem Minimum und anschließend mit weiter zunehmendem Ladezustand der Batterie wieder steigt, so kann durch die Bestimmung des Innenwiderstands in zwei aufeinanderfolgenden Zeitschritten während des Ladens der Batterie auf einfache Weise ermittelt werden, ob man sich gegenwärtig auf dem bis zum Minimum fallenden Ast der Kennlinie oder auf dem steigenden Ast auf der anderen Seite des Minimums befindet. Kommen nun für den aktuellen Ladezustandswert zwei mögliche Ladezustandswerte aus dem Kennlinienfeld in Betracht, wobei sich diese beiden Ladezustandswerte auf unterschiedlichen Seiten des Minimums der Kennlinie befinden, so kann diese Zweideutigkeit durch das eben beschriebene Auswahlverfahren, gemäß welchem zeitlich aufeinanderfolgend bestimmte Innenwiderstandswerte in ihrer Größe verglichen werden, aufgelöst werden. Dazu ist insbesondere auch die Kenntnis über die aktuelle Ladesituation der Batterie von Vorteil. Wenn also der Innenwiderstand mit zunehmendem Ladezustand der Batterie, wie dies beim Laden der Batterie der Fall ist, zeitlich abfällt, so würde entsprechend der Innenwiderstand in der umgekehrten Situation, das heißt beim Entladen der Batterie, im Verlauf der Zeit zunehmen. Durch diese drei genannten Informationen, das heißt der zusätzlichen Betrachtung eines in einem vorhergehenden Zeitschritt ermittelten Innenwiderstandswerts, der Information über die Art des Extremums der Kennlinie sowie die Information über einen aktuellen Ladezustand der Batterie, lässt sich somit vorteilhafterweise auch für Zellchemien, das heißt für Batterietypen, die nicht immer eine eindeutige Zuordnung zwischen dem Innenwiderstand und dem Ladezustand der Batterie zulassen, der richtige aktuelle Ladezustandswert einfach ermitteln.

Die aktuelle Ladesituation der Batterie kann dabei zum Beispiel auf einfache Weise mittels einer Strommessung eines Batteriestroms der Batterie bestimmt werden. In einer Batterie sind üblicherweise ohnehin diverse Sensoren, wie beispielsweise Temperatursensoren zur Ermittlung der aktuellen Batterietemperatur und auch Stromsensoren zur Ermittlung des Batteriegesamtstroms vorhanden, die somit vorteilhafterweise ebenso zur Ladezustandsbestimmung genutzt werden können. Der Batteriestrom stellt dabei den in oder aus der Batterie fließenden Gesamtstrom dar. Anhand des Vorzeichens dieses Stroms, das heißt der Stromrichtung, kann auf einfache Weise ermittelt werden, ob gerade Strom der Batterie entnommen wird, wie dies bei einer Entladesituation der Fall ist, oder ob der Batterie gerade Strom zugeführt wird, wie dies bei einer Aufladesituation der Batterie der Fall ist.

Bei einer weiteren vorteilhaften Ausgestaltung der Erfindung wird gemäß dem vorbestimmten Auswahlverfahren ein zweiter Ladezustandswert der Batterie mittels einer zeitlichen Stromintegration eines Batteriestroms der Batterie bestimmt und mit den mindestens zwei aus dem Kennlinienfeld bestimmten Ladezustandswerten verglichen, wobei derjenige der mindestens zwei Ladezustandswerte aus dem Kennlinienfeld mit dem aktuellen Ladezustandswert der Batterie gleichgesetzt wird, welcher einen geringeren Unterschied zum zweiten Ladezustandswert aufweist. Mit anderen Worten können zur Auflösung der oben beschriebenen Mehrdeutigkeit bei einer nicht eindeutigen Zuordnung zwischen dem Innenwiderstandswert und dem Ladezustand für einen oder mehrere vorbestimmte Temperaturbereiche auch aus dem Stand der Technik bekannte Verfahren zur Bestimmung des Ladezustands herangezogen werden. Dies ist insbesondere dann von großem Vorteil, wenn eine Kennlinie des Kennlinienfeldes für einen bestimmten Batterietyp mehrere Maxima oder Minima aufweist beziehungsweise im Allgemeinen mehr als nur ein Extremum. Dies ist zwar in der Praxis eher selten, dennoch kann gemäß dieser vorteilhaften Ausgestaltung der Erfindung zum Beispiel über das Stromintegral der Ladezustand als zweiter Ladezustandswert ermittelt und als Plausibilisierungsbedingung herangezogen werden. Zur Bereitstellung dieses zweiten Ladezustandswerts, das heißt der Bestimmung des aktuellen Ladezustandswerts der Batterie über eine weitere Methode, kommt jedoch nicht nur eine Stromintegration in Betracht, sondern auch andere eingangs beschriebene Verfahren zur Bestimmung des Ladezustands einer Batterie, wie diese aus dem Stand der Technik bekannt sind. So kann vorteilhafterweise für alle Eventualitäten immer zuverlässig der Ladezustandswert einer Batterie für einen bestimmten Batterietyp ermittelt werden.

Bei einer weiteren vorteilhaften Ausgestaltung der Erfindung wird der aktuelle Innenwiderstandswert als Quotient aus einer Spannungsänderung einer Batteriespannung, welche aus einer Änderung eines Batteriestroms der Batterie resultiert, und der Änderung des Batteriestroms ermittelt. Auch hier stellt der Batteriestrom wieder den in oder aus der Batterie fließenden Gesamtstrom dar. Insbesondere stellt dies eine übliche Methode zur Bestimmung des Innenwiderstands einer Batterie dar. Somit kann also der Innenwiderstand über das Strom- und Spannungsprofil bei einer Strombelastung und der sich daraus ergebenden Spannungsantwort, insbesondere als Quotient dieser Größen, bestimmt werden. Der Innenwiderstand lässt sich damit durch die Formel Ri = ΔU / ΔI beschreiben werden, wobei Ri den Innenwiderstand bezeichnet, ΔI die Strombelastung beziehungsweise die Änderung des Batteriestroms, wobei hier Strom und Stromstärke synonym verwendet werden, und ΔU die sich aus der Änderung des Batteriestroms ergebene Spannungsantwort, das heiß die Änderung der Batteriespannung. Auch hier können wiederum andere aus dem Stand der Technik bekannte Verfahren zur Bestimmung des Innenwiderstands zum Einsatz kommen, die nicht die Kenntnis des Ladezustands der Batterie voraussetzen.

Bei einer besonders vorteilhaften Ausgestaltung der Erfindung wird der aktuelle Innenwiderstandswert fortwährend wiederholt basierend auf einer fortwährenden Erfassung von Stromschwankungen eines gemessenen Batteriestroms der Batterie und von diesen Stromschwankungen zugeordneten Spannungsänderungen der Batteriespannung ermittelt, insbesondere wiederum als Quotient aus diesen Größen. Diese Ausführungsform der Erfindung beruht auf der Erkenntnis, dass kleine Stromschwankungen bedingt durch in der Regel ungewollte Schwankungen beziehungsweise Störungen des Bordnetzes vorteilhafterweise zur Innenwiderstandsbestimmung genutzt werden können. Derartige Störungen oder Schwankungen im Bordnetz führen zu Stromrippeln auf dem Batteriestrom, das heißt der Gleichstrom der Batterie wird von einem Wechselstrom überlagert. Durch eine entsprechende fortwährende Messung des Batteriestroms wie auch der Batteriespannung kann somit vorteilhafterweise aus den entsprechenden Stromschwankungen sowie aus diesen resultierenden Spannungsantworten fortwährend der Innenwiderstand der Batterie ermittelt werden. Dies hat den großen Vorteil, dass zur Innenwiderstandsmessung keine spezielle Situation initiiert werden muss, wie beispielsweise das gezielte Hervorrufen einer bestimmten Strombelastung, was wiederum den normalen Betrieb der Batterie stören würde und zum Beispiel wiederum nur im Stillstand des Kraftfahrzeugs oder ähnliches durchgeführt werden könnte. Durch diese vorteilhafte Ausgestaltung der Erfindung jedoch lässt sich der Innenwiderstandswert der Batterie permanent ermitteln und überwachen, sodass sich letztendlich daraus auch eine permanente und kontinuierliche Überwachungsmöglichkeit des Ladezustands der Batterie ergibt. Diese fortwährende Überwachung beziehungsweise Berechnung des Innenwiderstands ermöglicht darüber hinaus auch auf besonders vorteilhafter Weise oben beschriebene Ausgestaltung zur Auflösung von Mehrdeutigkeiten bei der Zuordnung eines Innenwiderstandswerts zu einem Ladezustandswert, falls die entsprechende Kennlinie eines oder mehrere Extrema aufweist. In einer solchen Situation können solche Mehrdeutigkeiten einfach durch die Betrachtung des zeitlichen Verlaufs des Innenwiderstands gelöst werden, was durch diese beschriebene vorteilhafte Ausgestaltung der Erfindung nun auf einfache zuverlässige Weise möglich ist, da diese eine kontinuierliche oder quasi-kontinuierliche Bestimmung des Innenwiderstands in jeder Situation ermöglicht.

Des Weiteren betrifft die Erfindung eine Batterieanordnung mit einer Batterie eines bestimmten Batterietyps und einer Steuereinrichtung zum Bestimmen eines aktuellen Ladezustandswerts der Batterie. Dabei weist die Steuereinrichtung einen Speicher auf, in welchem ein Kennlinienfeld gespeichert ist, welches für jeweilige verschiedene vorbestimmte Temperaturbereiche einen Innenwiderstand für den bestimmten Batterietyp in Abhängigkeit von dem Ladezustand für den bestimmten Batterietyp angibt. Dabei weist die Batterieanordnung eine Sensoreinrichtung auf, die dazu ausgelegt ist, eine aktuelle Temperatur der Batterie zu erfassen und einen aktuellen Innenwiderstandswert der Batterie zu ermitteln, wobei die Steuereinrichtung dazu ausgelegt ist, auf Basis der aktuellen Temperatur und des aktuellen Innenwiderstandswerts den aktuellen Ladezustandswert der Batterie mittels des Kennlinienfeldes zu bestimmen. Weiterhin ist die Steuereinrichtung dazu ausgelegt, falls die gemessene aktuelle Temperatur in einem der vorbestimmten Temperaturbereiche liegt, in welchem die Abhängigkeit des Innenwiderstands vom Ladezustand für einen Innenwiderstandswert des Kennlinienfeldes ein Extremum aufweist, den Ladezustandswert der Batterie mittels des Kennlinienfeldes derart zu bestimmen, dass überprüft wird, ob mindestens zwei Ladezustandswerte im Kennlinienfeld existieren, die gemäß der Abhängigkeit dem gemessenen Innenwiderstandswert für den vorbestimmten Temperaturbereich, in welchem die aktuelle Temperatur liegt, zugeordnet ist, und falls ja, die mindestens zwei Ladezustandswerte aus dem Kennlinienfeld bestimmt werden und der aktuelle Ladezustandswert der Batterie gemäß einem vorbestimmten Auswahlverfahren mit einem der mindestens zwei Ladezustandswerte gleichgesetzt wird. Die Steuereinrichtung ist zudem dazu ausgelegt, gemäß dem vorbestimmten Auswahlverfahren den Ladezustandswert der Batterie mit einem der mindestens zwei aus dem Kennlinienfeld bestimmten Ladezustandswerte gleichzusetzen in Abhängigkeit von einem in einem vorhergehenden Zeitschritt ermittelten Innenwiderstandswert und/oder in Abhängigkeit von einer aktuellen Ladesituation der Batterie, das heißt in Abhängigkeit davon, ob die Batterie aktuell geladen oder entladen wird.

Die Sensoreinrichtung kann beispielsweise zur Erfassung der aktuellen Temperatur einen Temperatursensor, der in die Batterie integriert ist, aufweisen. Darüber hinaus kann die Sensoranordnung zur Bestimmung des aktuellen Innenwiderstandswerts der Batterie zumindest einen Stromsensor sowie einen Spannungssensor zur Erfassung des Batteriestroms und der Batteriespannung aufweisen.

Darüber hinaus betrifft die Erfindung auch ein Kraftfahrzeug mit einer erfindungsgemäßen Batterieanordnung oder einer ihrer Ausgestaltungen.

Des Weiteren gelten die im Zusammenhang mit dem erfindungsgemäßen Verfahren und seinen Ausgestaltungen beschriebenen Vorteile in gleicher Weise für die erfindungsgemäße Batterieanordnung und das erfindungsgemäße Kraftfahrzeug. Darüber hinaus ermöglichen die im Zusammenhang mit dem erfindungsgemäßen Verfahren und seinen Ausgestaltungen beschriebenen Verfahrensschritte die Weiterbildung der erfindungsgemäßen Batterieanordnung und des erfindungsgemäßen Kraftfahrzeugs durch weitere korrespondierende gegenständliche Merkmale.

Weiterhin umfasst die Erfindung auch die Kombinationen der beschriebenen Ausführungsformen.

Im Folgenden sind Ausführungsbeispiele der Erfindung beschrieben. Hierzu zeigt:
- Fig. 1: eine schematische Darstellung eines Kraftfahrzeugs mit einer Batterieanordnung gemäß einem Ausführungsbeispiel der Erfindung; und
- Fig. 2: eine schematische Darstellung einer Kennlinie, welche den Zusammenhang zwischen dem Innenwiderstand und dem Ladezustand für einen bestimmten Batterietyp und einen bestimmten Temperaturbereich beschreibt, auf Basis von welcher der Ladezustand der Batterie gemäß einem Ausführungsbeispiel der Erfindung ermittelt wird.

Bei den im Folgenden erläuterten Ausführungsbeispielen handelt es sich um bevorzugte Ausführungsformen der Erfindung. Bei den Ausführungsbeispielen stellen die beschriebenen Komponenten der Ausführungsformen jeweils einzelne, unabhängig voneinander zu betrachtende Merkmale der Erfindung dar, welche die Erfindung jeweils auch unabhängig voneinander weiterbilden und damit auch einzeln oder in einer anderen als der gezeigten Kombination als Bestandteil der Erfindung anzusehen sind. Des Weiteren sind die beschriebenen Ausführungsformen auch durch weitere der bereits beschriebenen Merkmale der Erfindung ergänzbar.

In den Figuren sind funktionsgleiche Elemente jeweils mit denselben Bezugszeichen versehen.

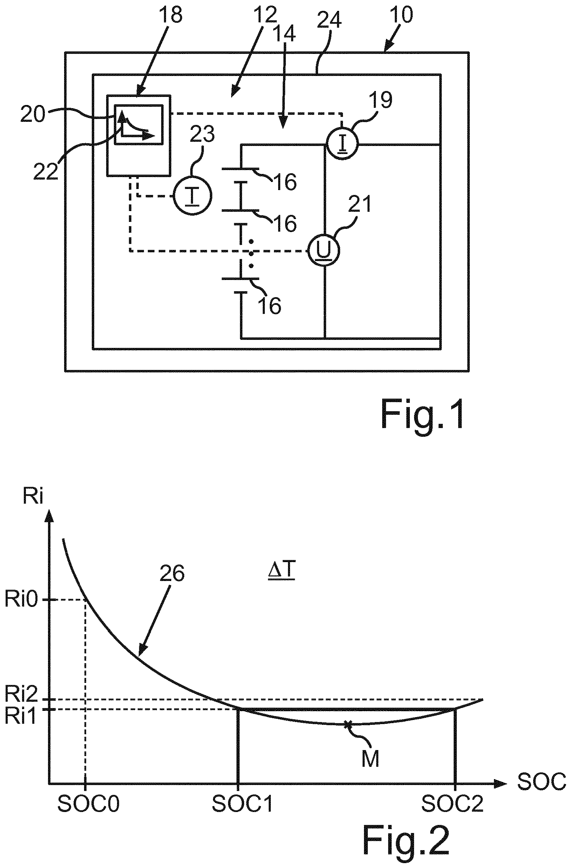

Fig. 1 zeigt eine schematische Darstellung eines Kraftfahrzeugs 10 mit einer Batterieanordnung 12 gemäß einem Ausführungsbeispiel der Erfindung. Die Batterieanordnung 12 umfasst dabei eine Batterie 14, welche mehrere Batteriezellen 16, wie zum Beispiel Lithium-Ionen-Zellen, aufweist. Zudem umfasst die Batterieanordnung 12 eine Steuereinrichtung 18, welche einen Speicher 20 aufweist, in welchem ein Kennlinienfeld 22 gespeichert ist. Dieses Kennlinienfeld 22 korrespondiert dabei zum Batterietyp beziehungsweise der Zellchemie der Batterie 14. Mit anderen Worten wurde das Kennlinienfeld 22 mittels einer Testbatterie erstellt, die vom gleichen Batterietyp wie die vorliegende Batterie 14 ist und damit die gleiche Zellchemie aufweist. Dieses Kennlinienfeld 22 beschreibt also für den Batterietyp der Batterie 14 für jeweilige vorbestimmte verschiedene Temperaturbereiche den Zusammenhang zwischen dem Innenwiderstand für den bestimmten Batterietyp und dem Ladezustand für den bestimmten Batterietyp. Um also den aktuellen Ladezustandswert der Batterie 14 zu ermitteln, kann die Steuereinrichtung 18 auf Basis einer aktuell erfassten Temperatur T und eines aktuell ermittelten Innenwiderstandswerts auf Basis dieses Kennlinienfeldes 22 den aktuellen Ladezustandswert der Batterie 14 bestimmen. Zur Erfassung der aktuellen Batterietemperatur T kann ein entsprechender Temperatursensor 23 verwendet werden, der vorzugsweise in der Nähe der Batterie 14, insbesondere in der Nähe der Batteriezellen 16, angeordnet ist. Auch können mehrere Temperatursensoren 23 zur Erfassung der aktuellen Temperatur T der Batterie 14 verwendet werden und vorgesehen sein. Darüber hinaus kann der aktuelle Innenwiderstandswert auf Basis eines Strom- und Spannungsprofils bei einer Strombelastung und der sich daraus ergebenden Spannungsantwort bestimmt werden. Hierzu kann die Batterieanordnung 12 weiterhin einen Stromsensor 19 sowie einen Spannungssensor 21 aufweisen. Mittels des Stromsensors 19 kann der Batteriestrom I erfasst werden, der der Batterie entnommen beziehungsweise zugeführt wird, je nach Situation. Weiterhin kann mittels des Spannungssensors 21 die an der Batterie 14 abgreifbare Gesamtspannung U erfasst werden. Die mittels dieser Sensoren das heißt des Stromsensors 19, des Spannungssensors 21 und des Temperatursensors 23 erfassten Messgrößen T, I, U können dabei fortwährend der Steuereinrichtung 18 zugeführt werden, die auf Basis dieser Größen und basierend auf dem Kennlinienfeld 22 den entsprechenden aktuellen Ladezustandswert der Batterie 14 bestimmt. Die Steuereinrichtung 18 kann dabei insbesondere in ein Batteriegehäuse 24 integriert sein, in welchem auch die Batterie 14 aufgenommen ist. Die Steuereinrichtung 18 kann dabei auch Teil eines Batteriemanagementsystems der Batterieanordnung 12 sein.

Fig. 2 zeigt eine grafische Darstellung einer Kennlinie 26 für einen vorbestimmten Temperaturbereich ΔT, die die Abhängigkeit zwischen dem Innenwiderstand Ri und dem Ladezustand SOC beschreibt. Wird nun beispielsweise von der Steuereinrichtung 18 eine aktuelle Temperatur T erfasst, welche in diesem vorbestimmten Temperaturbereich ΔT liegt, so kann die Steuereinrichtung 18 nun auf Basis des Kennlinienfeldes 22, insbesondere der für diesen vorbestimmten Temperaturbereich ΔT vorliegenden Kennlinie 26, zu dem aktuell ermittelten Innenwiderstand Ri den gemäß dem Kennlinienfeld 26 zugeordneten Ladezustand SOC der Batterie 14 ermitteln. In diesem in Fig. 2 dargestellten Beispiel ist die Abhängigkeit zwischen dem Innenwiderstand Ri und dem Ladezustand SOC jedoch nicht über den gesamten Bereich hinweg eindeutig. In diesem Beispiel weist also die Kennlinie 26 ein Minimum M auf. Wird zum Beispiel, wie hier exemplarisch dargestellt ist, ein erster Innenwiderstandswert Ri0 ermittelt, für welchen eine eindeutige Zuordnung zum Ladezustand SOC möglich ist, so wird gemäß dieser eindeutigen Zuordnung dem ermittelten Innenwiderstandswert Ri0 der korrespondierende Ladezustandswert SOC0 zugeordnet. Wird jedoch ein Innenwiderstandswert Ri1 ermittelt, für welchen die Zuordnung nicht eindeutig, sondern, wie hier dargestellt, zweideutig ist, so kann die Ermittlung des zugeordneten Ladezustandswerts wie folgt erfolgen: Weist die Kennlinie 26 nur ein einziges Minimum M auf, so kommen in dieser Situation höchstens zwei potentielle Kandidaten für den Ladezustandswert infrage, die hier exemplarisch mit SOC1 und SOC2 bezeichnet sind. Weiterhin kann vorteilhafterweise der in einem Zeitschritt zuvor bestimmte Innenwiderstandswert, der hier exemplarisch mit Ri2 bezeichnet ist, betrachtet werden. Zusätzlich wird auch bestimmt, ob sich die Batterie 14 gerade in einem Zustand befindet, in welchem die Batterie 14 geladen wird oder in welchem die Batterie 14 entladen wird. Dies kann anhand der Messung des Stroms I durch den Stromsensor 19 auf einfache Weise bestimmt werden. Wird also beispielsweise festgestellt, dass die Batterie 14 aktuell geladen wird, das heißt der Ladezustand SOC mit der Zeit steigt und der in dem Zeitschritt zuvor ermittelte Innenwiderstand Ri2 der Batterie 14 größer ist als der aktuell ermittelte Innenwiderstandswert Ri1, so folgt daraus, dass der Innenwiderstand Ri mit zunehmendem Ladezustand SOC abfällt. Dies wiederum bedeutet, dass sich der aktuell ermittelte Innenwiderstandswert Ri1 sowie auch der zeitlich zuvor ermittelte Innenwiderstandswert Ri2 bezogen auf die Darstellung in Fig. 2 auf der linken Seite des Minimums M befinden müssen. Hieraus ergibt sich also, dass der zum aktuell gemessenen Innenwiderstand Ri1 korrespondierende Ladezustandswert sich ebenfalls links vom Minimum M befinden muss und entsprechend den mit SOC1 bezeichneten Ladezustandswert darstellt. Würde man stattdessen eine Situation betrachten, in welcher die Batterie 14 gerade entladen wird, so ergäbe sich genau der umgekehrte Fall und der zum aktuell gemessenen Innenwiderstandswert Ri1 korrespondierende Ladezustandswert läge rechts vom Minimum M und stellt damit den mit SOC2 bezeichneten Ladezustandswert dar. Durch die Betrachtung des zeitlichen Verlaufs des Innenwiderstands Ri kann also vorteilhafterweise auch bei nicht eindeutigen Zuordnungen zwischen Innenwiderstand Ri und Ladezustand SOC erkannt werden, an welcher Stelle der Kennlinie 26 man sich gerade befindet. Sollten zudem Fälle auftreten, in denen eine solche Kennlinie 26 mehrere Maxima oder Minima aufweist, was in der Praxis eher unüblich ist, so kann beispielsweise zusätzlich der über ein Stromintegral bestimmte Ladezustand als Plausibilisierungsbedingung herangezogen werden.

Optional kann bei dieser Vorgehensweise, das heißt bei der Kennlinienfeld basierten Bestimmung des Ladezustands SOC, das Alter der Batterie 14 berücksichtigt werden, zum Beispiel indem der ermittelte Innenwiderstand Ri mit einem entsprechenden Faktor multipliziert wird, der vom Alter der Batterie 14 abhängig ist. Der Faktor ist dabei größer als 1 und umso größer, je höher das Alter der Batterie 14 ist. Auch dieser Faktor lässt sich experimentell speziell für jeden Batterietyp, das heißt für jede Zellchemie, ermitteln.

Insgesamt lässt sich so durch die Erfindung und ihre Ausgestaltungen eine besonders einfache und effektive, jederzeit einsetzbare und vor allem auch chemieunabhängige Methode zur Ladezustandsbestimmung beziehungsweise zur Ladezustandsrekalibrierung bereitstellen.

## Patentansprüche

1. Verfahren zur Bestimmung eines aktuellen Ladezustandswerts (SOCO, SOC1, SOC2) einer Batterie (14) eines bestimmten Batterietyps, aufweisend die Schritte:
a) Bereitstellen eines Kennlinienfeldes (22), welches für jeweilige verschiedene vorbestimmte Temperaturbereiche (ΔT) einen Innenwiderstand (Ri) für den bestimmten Batterietyp in Abhängigkeit (26) von dem Ladezustand (SOC) für den bestimmten Batterietyp angibt,
b) Messen einer aktuellen Temperatur (T) der Batterie (14);
c) Ermitteln eines aktuellen Innenwiderstandswerts (RiO, Ri1) der Batterie (14); und
d) Auf Basis der aktuellen Temperatur (T) und des aktuellen Innenwiderstandswerts (RiO, Ri1) Bestimmen des aktuellen Ladezustandswerts (SOCO, SOC1, SOC2) der Batterie (14) mittels des Kennlinienfeldes (22);
**dadurch gekennzeichnet, dass**
falls die gemessene aktuelle Temperatur (T) in einem der vorbestimmten Temperaturbereiche (ΔT) liegt, in welchem die Abhängigkeit (26) des Innenwiderstands (Ri) vom Ladezustand (SOC) für einen Innenwiderstandswert (RiO, Ri1) des Kennlinienfeldes (22) ein Extremum (M) aufweist, der Ladezustandswert (SOC1, SOC2) der Batterie (14) mittels des Kennlinienfeldes (22) derart bestimmt wird, dass überprüft wird, ob mindestens zwei Ladezustandswerte (SOC1, SOC2) im Kennlinienfeld (22) existieren, die gemäß der Abhängigkeit (26) dem gemessenen Innenwiderstandswert (RiO, Ri1) für den vorbestimmten Temperaturbereich (ΔT), in welchem die aktuelle Temperatur (T) liegt, zugeordnet sind, und falls ja, die mindestens zwei Ladezustandswerte (SOC1, SOC2) aus dem Kennlinienfeld (22) bestimmt werden, und der aktuelle Ladezustandswert (SOC1, SOC2) der Batterie (14) gemäß einem vorbestimmten Auswahlverfahren mit einem der mindestens zwei Ladezustandswerte (SOC1, SOC2) gleichgesetzt wird, wobei gemäß dem vorbestimmten Auswahlverfahren der Ladezustandswert (SOC1, SOC2) der Batterie (14) mit einem der mindestens zwei aus dem Kennlinienfeld (22) bestimmten Ladezustandswerte (SOC1, SOC2) gleichgesetzt wird in Abhängigkeit von:
- einem in einem vorhergehenden Zeitschritt ermittelten Innenwiderstandswert (Ri2); und/oder
- einer aktuellen Ladesituation der Batterie (14), d.h. in Abhängigkeit davon ob die Batterie (14) aktuell geladen oder entladen wird.

2. Verfahren nach Anspruch 1,
**dadurch gekennzeichnet, dass**
falls die gemessene aktuelle Temperatur (T) in einem der vorbestimmten Temperaturbereiche (ΔT) liegt, in welchem die Abhängigkeit (26) des Innenwiederstands (Ri) von dem Ladezustand (SOC) streng monoton steigt oder fällt, der Ladezustandswert (SOCO, SOC1, SOC2) der Batterie (14) mittels des Kennlinienfeldes (22) derart bestimmt wird, dass der Ladezustandswert (SOCO, SOC1, SOC2) der Batterie (14) gleich einem Ladezustandswert (SOCO, SOC1, SOC2) des Kennlinienfeldes (22) gesetzt wird, der für den vorbestimmten Temperaturbereich (ΔT), in welchem die aktuell gemessene Temperatur (T) der Batterie (14) liegt, gemäß der Abhängigkeit dem aktuell gemessenen Innenwiderstandswert (RiO, Ri1) zugeordnet ist.

3. Verfahren nach einem der vorhergehenden Ansprüche,
**dadurch gekennzeichnet, dass**
gemäß dem vorbestimmten Auswahlverfahren der Ladezustandswert (SOC1, SOC2) der Batterie (14) mit einem der mindestens zwei aus dem Kennlinienfeld (22) bestimmten Ladezustandswerte (SOC1, SOC2) gleichgesetzt wird in Abhängigkeit von der Art des Extremums (M), d.h. in Abhängigkeit davon, ob das Extremum ein Minimum (M) oder ein Maximum darstellt.

4. Verfahren nach einem der vorhergehenden Ansprüchen,
**dadurch gekennzeichnet, dass**
die aktuelle Ladesituation mittels einer Strommessung eines Batteriestroms (I) der Batterie (14) bestimmt wird.

5. Verfahren nach einem der vorhergehenden Ansprüche,
**dadurch gekennzeichnet, dass**
gemäß dem vorbestimmten Auswahlverfahren ein zweiter Ladezustandswert der Batterie (14) mittels einer zeitlichen Stromintegration eines Batteriestroms (I) der Batterie (14) bestimmt wird und mit den mindestens zwei aus dem Kennlinienfeld (22) bestimmten Ladezustandswerten (SOC1, SOC2) verglichen wird, und derjenige der mindestens zwei Ladezustandswerte (SOC1, SOC2) aus dem Kennlinienfeld (22) mit dem aktuellen Ladezustandswert (SOC1, SOC2) der Batterie (14) gleichgesetzt wird, welcher einen geringeren Unterschied zum zweiten Ladezustandswert aufweist.

6. Verfahren nach einem der vorhergehenden Ansprüche,
**dadurch gekennzeichnet, dass**
der aktuelle Innenwiderstandswert (RiO, Ri1) als Quotient aus einer Spannungsänderung einer Batteriespannung (U), welche aus einer Änderung eines Batteriestroms (I) der Batterie (14) resultiert, und der Änderung des Batteriestroms (I) ermittelt wird.

7. Verfahren nach einem der vorhergehenden Ansprüche,
**dadurch gekennzeichnet, dass**
der aktuelle Innenwiderstandswert (RiO, Ri1) fortwährend wiederholt basierend auf einer fortwährenden Erfassung von Stromschwankungen eines gemessenen Batteriestroms (I) der Batterie (14) und auf diesen Stromschwankungen zugeordneten Spannungsänderungen der Batteriespannung (U) ermittelt wird.

8. Batterieanordnung (12) mit einer Batterie (14) eines bestimmten Batterietyps und einer Steuereinrichtung (18) zum Bestimmen eines aktuellen Ladezustandswerts (SOCO, SOC1, SOC2) der Batterie (14), wobei die Steuereinrichtung (18) einen Speicher (20) aufweist, in welchem ein Kennlinienfeld (22) gespeichert ist, welches für jeweilige verschiedene vorbestimmte Temperaturbereiche (ΔT) einen Innenwiderstand (Ri) für den bestimmten Batterietyp in Abhängigkeit von dem Ladezustand (SOC) für den bestimmten Batterietyp angibt, wobei die Batterieanordnung (12) eine Sensoreinrichtung (19, 21, 23) aufweist, die dazu ausgelegt ist, eine aktuelle Temperatur (T) der Batterie (14) zu erfassen und einen aktuellen Innenwiderstandswert (RiO, Ri1) der Batterie (14) zu ermitteln, wobei die Steuereinrichtung (18) dazu ausgelegt ist, auf Basis der aktuellen Temperatur (T) und des aktuellen Innenwiderstandswerts (RiO, Ri1) den aktuellen Ladezustandswert (SOCO, SOC1, SOC2) der Batterie (14) mittels des Kennlinienfeldes (22) zu bestimmen,
**dadurch gekennzeichnet, dass**
die Steuereinrichtung (18) dazu ausgelegt ist, falls die gemessene aktuelle Temperatur (T) in einem der vorbestimmten Temperaturbereiche (ΔT) liegt, in welchem die Abhängigkeit (26) des Innenwiderstands (Ri) vom Ladezustand (SOC) für einen Innenwiderstandswert (RiO, Ri1) des Kennlinienfeldes (22) ein Extremum (M) aufweist, den Ladezustandswert (SOC1, SOC2) der Batterie (14) mittels des Kennlinienfeldes (22) derart zu bestimmen, dass überprüft wird, ob mindestens zwei Ladezustandswerte (SOC1, SOC2) im Kennlinienfeld (22) existieren, die gemäß der Abhängigkeit (26) dem gemessenen Innenwiderstandswert (RiO, Ri1) für den vorbestimmten Temperaturbereich (ΔT), in welchem die aktuelle Temperatur (T) liegt, zugeordnet sind, und falls ja, die mindestens zwei Ladezustandswerte (SOC1, SOC2) aus dem Kennlinienfeld (22) bestimmt werden, und der aktuelle Ladezustandswert (SOC1, SOC2) der Batterie (14) gemäß einem vorbestimmten Auswahlverfahren mit einem der mindestens zwei Ladezustandswerte (SOC1, SOC2) gleichgesetzt wird, wobei die Steuereinrichtung (18) dazu ausgelegt ist, gemäß dem vorbestimmten Auswahlverfahren den Ladezustandswert (SOC1, SOC2) der Batterie (14) mit einem der mindestens zwei aus dem Kennlinienfeld (22) bestimmten Ladezustandswerte (SOC1, SOC2) gleichzusetzen in Abhängigkeit von:
- einem in einem vorhergehenden Zeitschritt ermittelten Innenwiderstandswert (Ri2); und/oder
- einer aktuellen Ladesituation der Batterie (14), d.h. in Abhängigkeit davon ob die Batterie (14) aktuell geladen oder entladen wird.

9. Kraftfahrzeug (10) mit einer Batterieanordnung (12) nach Anspruch 8.

## Claims

1. Method for determining a current charge level (SOCO, SOC1, SOC2) of the battery (14) of a specified battery type, having the steps:
a) providing a characteristic map (22) which for respective various predetermined temperature ranges (ΔT) specifies an internal resistance (Ri) for the specified battery type as a dependency (26) on the charge level (SOC) for the specified battery type,
b) measuring a current temperature (T) of the battery (14);
c) determining a current internal resistance value (RiO, Ri1) of the battery (14); and
d) on the basis of the current temperature (T) and the current internal resistance value (RiO, Ri1) specifying the current charge level (SOCO, SOC1, SOC2) of the battery (14) by means of the characteristic map (22);
**characterized in that**
in the case that the measured current temperature (T) lies in one of the prespecified temperature ranges (AT), in which the dependency (26) of the internal resistance (Ri) on the charge level (SOC) for an internal resistance value (RiO, Ri1) of the characteristic map (22) has an extreme (M), the charge level (SOC1, SOC2) of the battery (14) is specified by means of the characteristic map (22) such that it is verified whether at least two charge levels (SOC1, SOC2) exist in the characteristic map (22), which according to the dependency (26) are assigned to the measured internal resistance value (RiO, Ri1) for the prespecified temperature range (AT) in which the current temperature (T) lies, and in this case, the at least two charge levels (SOC1, SOC2) are specified from the characteristic map (22), and the current charge level (SOC1, SOC2) of the battery (14) is equated, according to a prespecified selection method, with one of the at least two charge levels (SOC1, SOC2), wherein according to the prespecified selection method the charge level (SOC1, SOC2) of the battery (14) is equated with one of the at least two charge levels (SOC1, SOC2) specified from the characteristic map (22) depending on:
- an internal resistance value (Ri2) determined in a previous time step; and/or
- a current charging situation of the battery (14), i.e. depends on whether the battery (14) is currently being charged or being discharged.

2. Method according to claim 1,
**characterized in that**
in the case that the measured current temperature (T) lies in one of the prespecified temperature ranges (AT), in which the dependency (26) of the internal resistance (Ri) on the charge level (SOC) rises or falls in a strictly monotonous manner, the charge level (SOCO, SOC1, SOC2) of the battery (14) is specified by means of the characteristic map (22) such that the charge level (SOCO, SOC1, SOC2) of the battery (14) is set to be equal to a charge level (SOCO, SOC1, SOC2) of the characteristic map (22), which for the prespecified temperature range (AT) in which the currently measured temperature (T) of the battery (14) lies is assigned to the currently measured internal resistance value (RiO, Ri1) according to the dependency.

3. Method according to any of the preceding claims,
**characterized in that**
according to the prespecified selection method the charge level (SOC1, SOC2) of the battery (14) is equated with one of the at least two charge levels (SOC1, SOC2) specified from the characteristic map (22) depending on the type of the extreme (M), i.e. depending on whether the extreme constitutes a minimum (M) or a maximum.

4. Method according to any of the preceding claims,
**characterized in that**
the current charging situation is specified by means of a current measurement of a battery current (I) of the battery (14).

5. Method according to any of the preceding claims,
**characterized in that**
according to the prespecified selection method a second charge value of the battery (14) is specified by means of a temporal current integration of a battery current (I) of the battery (14) and is compared with the at least two charge values (SOC1, SOC2) specified from the characteristic map (22), and the one of the at least two charge values (SOC1, SOC2) from the characteristic map (22) is equated with the current charge value (SOC1, SOC2) of the battery (14), which has a lesser deviation from the second charge level.

6. Method according to any of the preceding claims,
**characterized in that**
the current internal resistance value (RiO, Ri1) is determined as a quotient from a voltage change of a battery voltage (U), which results from a change in a battery current (I) of the battery (14) and the change in the battery current (I).

7. Method according to any of the preceding claims,
**characterized in that**
the current internal resistance value (RiO, Ri1) repeats continuously on the basis of a continuous capturing of current fluctuations of a measured battery current (I) of the battery (14) and on the basis of voltage changes in the battery voltage (U) assigned to these current fluctuations.

8. Battery arrangement (12) having a battery (14) of a specified battery type and a control apparatus (18) for specifying a current charge level (SOCO, SOC1, SOC2) of the battery (14), wherein the control apparatus (18) has a memory (20) in which a characteristic map (22) is stored which indicates for respective various prespecified temperature ranges (AT) an internal resistance (Ri) for the specified battery type dependent on the charge level (SOC) for the specified battery type, wherein the battery arrangement (12) has a sensor apparatus (19, 21, 23), which is configured to detect a current temperature (T) of the battery (14) and to determine a current internal resistance value (RiO, Ri1) of the battery (14), wherein the control apparatus (18) is configured, on the basis of the current temperature (T) and the current internal resistance value (RiO, Ri1), to specify the current charge level (SOCO, SOC1, SOC2) of the battery (14) by means of the characteristic map (22),
**characterized in that**
the control apparatus (18) is configured, in the case that the measured current temperature (T) lies in one of the prespecified temperature ranges (ΔT) in which the dependency (26) of the internal resistance (Ri) on the charge level (SOC) for an internal resistance value (RiO, Ri1) of the characteristic map (22) has an extreme (M), to specify the charge level (SOC1, SOC2) of the battery (14) by means of the characteristic map (22) such that it is verified whether at least two charge levels (SOC1, SOC2) exist in the characteristic map (22) which according to the dependency (26) are assigned to the measured internal resistance (RiO, Ri1) for the prespecified temperature region (AT) in which the current temperature (T) lies, and in this case, the at least two charge levels (SOC1, SOC2) are specified from the characteristic map (22) and the current charge level (SOC1, SOC2) of the battery (14) is equated with one of the at least two charge levels (SOC1, SOC2) according to a prespecified selection method, wherein the control apparatus (18) is configured to equate the charge level (SOC1, SOC2) of the battery (14) with one of the at least two charge levels (SOC1, SOC2) specified from the characteristic map (22) according to the prespecified selection method, depending on:
- an internal resistance value (Ri2) determined in a previous time step; and/or
- a current charging situation of the battery (14), i.e. depends on whether the battery (14) is currently being charged or being discharged.

9. Motor vehicle (10) having a battery arrangement (12) according to claim 8.

## Revendications

1. Procédé de détermination d'une valeur d'état de charge actuelle (SOCO, SOC1, SOC2) d'une batterie (14) d'un type de batterie déterminé, présentant les étapes de :
a) fourniture d'un champ caractéristique (22) qui indique pour différentes plages de températures prédéterminées respectives (ΔT) une résistance interne (Ri) pour le type de batterie déterminé en fonction (26) de l'état de charge (SOC) pour le type de batterie déterminé,
b) mesure d'une température actuelle (T) de la batterie (14) ;
c) détermination d'une valeur de résistance interne actuelle (RiO, Ri1) de la batterie (14) ; et
d) sur la base de la température actuelle (T) et de la valeur de résistance interne actuelle (RiO, Ri1), détermination de la valeur d'état de charge actuelle (SOCO, SOC1, SOC2) de la batterie (14) au moyen du champ caractéristique (22) ;
**caractérisé en ce que**
dans le cas où la température actuelle mesurée (T) se situe dans une des plages de températures prédéterminées (AT) dans laquelle la dépendance (26) de la résistance interne (Ri) de l'état de charge (SOC) présente pour une valeur de résistance interne (RiO, Ri1) du champ caractéristique (22) une valeur extrême (M), la valeur d'état de charge (SOC1, SOC2) de la batterie (14) est déterminée au moyen du champ caractéristique (22) de telle sorte qu'il est vérifié si au moins deux valeurs d'état de charge (SOC1, SOC2) existent dans le champ caractéristique (22), valeurs qui sont associées conformément à la dépendance (26) à la valeur de résistance interne mesurée (RiO, Ri1) pour la plage de températures prédéterminée (AT) dans laquelle se trouve la température actuelle (T), et si oui, les au moins deux valeurs d'état de charge (SOC1, SOC2) sont déterminées à partir du champ caractéristique (22) et la valeur d'état de charge actuelle (SOC1, SOC2) de la batterie (14) est assimilée à une des au moins deux valeurs d'état de charge (SOC1, SOC2) conformément à un procédé de sélection prédéterminé, dans lequel conformément au procédé de sélection prédéterminé, la valeur d'état de charge (SOC1, SOC2) de la batterie (14) est assimilée à une des au moins deux valeurs d'état de charge (SOC1, SOC2) déterminées à partir du champ caractéristique (22) en fonction de :
- une valeur de résistance interne (Ri2) déterminée dans un pas de temps précédent ; et/ou
- une situation de charge actuelle de la batterie (14), c'est-à-dire en fonction du fait que la batterie (14) est actuellement chargée ou déchargée.

2. Procédé selon la revendication 1,
**caractérisé en ce que**
dans le cas où la température actuelle mesurée (T) se situe dans une des plages de températures prédéterminées (AT), dans laquelle la dépendance (26) de la résistance interne (Ri) à l'état de charge (SOC) augmente ou baisse de manière fortement monotone, la valeur d'état de charge (SOCO, SOC1, SOC2) de la batterie (14) est déterminée au moyen du champ caractéristique (22) de telle sorte que la valeur d'état de charge (SOCO, SOC1, SOC2) de la batterie (14) est fixée pour être égale à une valeur d'état de charge (SOCO, SOC1, SOC2) du champ caractéristique (22), valeur qui est associée à la valeur de résistance interne mesurée actuellement (RiO, Ri1), pour la plage de températures prédéterminée (AT) dans laquelle se trouve la température mesurée actuellement (T) de la batterie (14) conformément à la dépendance.

3. Procédé selon l'une quelconque des revendications précédentes,
**caractérisé en ce que**
conformément au procédé de sélection prédéterminé, la valeur d'état de charge (SOC1, SOC2) de la batterie (14) est assimilée à une des au moins deux valeurs d'état de charge (SOC1, SOC2) déterminées à partir du champ caractéristique (22) en fonction du type de la valeur extrême (M), c'est-à-dire en fonction du fait que la valeur extrême représente un minimum (M) ou un maximum.

4. Procédé selon l'une quelconque des revendications précédentes,
**caractérisé en ce que**
la situation de charge actuelle est déterminée au moyen d'une mesure de courant d'un courant de batterie (I) de la batterie (14).

5. Procédé selon l'une quelconque des revendications précédentes,
**caractérisé en ce que**
conformément au procédé de sélection prédéterminé, une seconde valeur d'état de charge de la batterie (14) est déterminée au moyen d'une intégration de courant temporelle d'un courant de batterie (I) de la batterie (14) et est comparée avec les au moins deux valeurs d'état de charge (SOC1, SOC2) déterminées à partir du champ caractéristique (22), et celle des au moins deux valeurs d'état de charge (SOC1, SOC2) issues du champ caractéristique (22) est assimilée à la valeur d'état de charge actuelle (SOC1, SOC2) de la batterie (14) qui présente une différence plus petite par rapport à la seconde valeur d'état de charge.

6. Procédé selon l'une quelconque des revendications précédentes,
**caractérisé en ce que**
la valeur de résistance interne actuelle (RiO, Ri1) est déterminée en tant que quotient à partir d'une modification de tension d'une tension de batterie (U) qui résulte d'une modification d'un courant de batterie (I) de la batterie (14) et de la modification du courant de batterie (I).

7. Procédé selon l'une quelconque des revendications précédentes,
**caractérisé en ce que**
la valeur de résistance interne actuelle (RiO, Ri1) est déterminée de manière continue et répétée en se basant sur une acquisition continue de fluctuations de courant d'un courant de batterie mesuré (I) de la batterie (14) et de modifications de tension de la tension de batterie (U) associées à ces fluctuations de courant.

8. Assemblage de batterie (12) avec une batterie (14) d'un type de batterie déterminé et un dispositif de commande (18) pour déterminer une valeur d'état de charge actuelle (SOCO, SOC1, SOC2, SOC3) de la batterie (14), dans lequel le dispositif de commande (18) présente un accumulateur (20) dans lequel un champ caractéristique (22) est stocké, qui indique pour différentes plages de températures prédéterminées respectives (AT) une résistance interne Ri) pour le type de batterie déterminé en fonction de l'état de charge (SOC) pour le type de batterie déterminé, dans lequel l'assemblage de batterie (12) présente un dispositif de détection (19, 21, 23) qui est conçu pour détecter une température actuelle (T) de la batterie (14) et déterminer une valeur de résistance interne actuelle (RiO, Ri1) de la batterie (14), dans lequel le dispositif de commande (18) est conçu pour déterminer la valeur d'état de charge actuelle (SOCO, SOC1, SOC2) de la batterie (14) au moyen du champ caractéristique (22) sur la base de la température actuelle (T) et de la valeur de résistance interne actuelle (RiO, Ri1),
**caractérisé en ce que**
le dispositif de commande (18) est conçu, dans le cas où la température actuelle mesurée (T) se situe dans une des plages de températures prédéterminées (ΔT) dans laquelle la dépendance (26) de la résistance interne (Ri) de l'état de charge (SOC) présente pour une valeur de résistance interne (RiO, Ri1) du champ caractéristique (22) une valeur extrême (M), pour déterminer la valeur d'état de charge (SOC1, SOC2) de la batterie (14) au moyen du champ caractéristique (22) de telle sorte qu'il est vérifié si au moins deux valeurs d'état de charge (SOC1, SOC2) existent dans le champ caractéristique (22), qui sont associées conformément à la dépendance (26) à la valeur de résistance interne mesurée (RiO, Ri1) pour la plage de températures prédéterminées (AT), dans laquelle se trouve la température actuelle (T), et si oui, les au moins deux valeurs d'état de charge (SOC1, SOC2) sont déterminées à partir du champ caractéristique (22) et la valeur d'état de charge actuelle (SOC1, SOC2) est assimilée à une des au moins deux valeurs d'état de charge (SOC1, SOC2), dans lequel le dispositif de commande (18) est conçu pour assimiler conformément au procédé de sélection prédéterminé la valeur d'état de charge (SOC1, SOC2) de la batterie (14) avec une des au moins deux valeurs d'état de charge SOC1, SOC2) déterminées à partir du champ caractéristique (22) en fonction de :
- une valeur de résistance interne (Ri2) déterminée dans un pas de temps précédent ; et/ou
- une situation de charge actuelle de la batterie (14), c'est-à-dire en fonction du fait que la batterie (14) est actuellement chargée ou déchargée.

9. Véhicule à moteur (10) avec un assemblage de batterie (12) selon la revendication 8.
